(19) Europäisches Patentamt
European Patent Office
Office européen des brevets

(11) EP 1 912 259 A1

(12) **EUROPEAN PATENT APPLICATION**

(43) Date of publication:
16.04.2008 Bulletin 2008/16

(51) Int Cl.:
*H01L 31/0352* (2006.01)   *H01L 31/09* (2006.01)
*H01L 31/109* (2006.01)   *G01K 7/22* (2006.01)
*H01L 27/146* (2006.01)   *H01L 29/12* (2006.01)

(21) Application number: 06122274.1

(22) Date of filing: 13.10.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK RS

(71) Applicant: Acreo AB
164 40 Kista (SE)

(72) Inventors:
• **Höglund, Linda**
**582 32, Linköping (SE)**

• **Wissmar, Stanley**
**194 71, Upplands Väsby (SE)**
• **Andersson, Jan**
**171 42, Solna (SE)**

(74) Representative: **Skagersten, Thomas**
**Awapatent AB,**
**Box 45086**
**104 30 Stockholm (SE)**

(54) **A quantum dot thermistor structure and use thereof**

(57) The present invention provides a solid state structure (2) for thermal sensing. The solid state structure comprises a thermistor layer (12) having quantum dots (QD) embedded in a barrier material (BM). Using such a structure, high temperature coefficient for a wide range of material combinations can be obtained. Further, such structures enable the realisation of efficient thermal detectors suitable for e.g. infrared detection applications.

FIG 1a

Printed by Jouve, 75001 PARIS (FR)

EP 1 912 259 A1

FIG 1b

**Description**

Technical Field of the Invention

The present invention relates to a solid-state structure, in particular to a structure comprising a thermistor layer and acting as a sensitive structure in e.g. infrared detectors.

Background of the Invention

In general, light sensitive detectors, e.g. infrared detectors, can be classified into two main categories, namely photon detectors and thermal detectors. These two types of detectors, whose operation principles differ significantly from one another, are briefly described below.

The operation principle of a photon detector is to measure an electric current induced by absorption of light in its structure, so-called photo-induced current. In such a detector, charge carriers are trapped in the structure under steady-state conditions (conditions obtained in darkness), and then released when the structure is exposed to light, such as infrared radiation, since photon energy is given to the charge carriers to enable them to move from one electronic state to another. A critical parameter of such a detector is the dark current, which, for efficient detection and noise reduction, should be minimized as much as possible. Photon detectors present the advantages of being fast and sensitive but usually require cooling to cryogenic temperatures to achieve good detection.

The operation principle of a thermal detector is rather different since, in this case, the incoming radiation, e.g. infrared radiation, is detected by electrically converting a raise in temperature induced by the surrounding radiation to, typically, a change in resistance. The sensitive structure of such detectors is therefore designed to absorb as much of the incoming radiation as possible and to enhance a change in temperature in the structure. Thus, the sensitive structure of a thermal detector typically is provided with a heating absorption layer at the side of incidence of the incoming radiation, in order to minimize reflection, and a reflector layer at the other side in order to reflect transmitted radiation. Moreover, the material comprised between the absorption layer and the reflector layer normally is a material whose resistance varies rapidly and predictably with temperature, i.e. a thermistor, also called a thermistor layer in the following. The operation principle is commonly described as a two-stage process where first the whole structure is heated because of e.g. infrared absorption and then a change in resistance induced by this heating is measured across the thermistor layer. The change in resistance is obtained by measuring a voltage difference across the thermistor layer while *forcing* an electric current to flow through it, as opposed to photon detectors where the current is photo-induced. The obtained electrical signal can then be amplified, displayed in a conventional thermal detector, and related to the amount of radiation.

A critical parameter of a thermistor layer is its temperature coefficient, which should be as high as possible in order to achieve an efficient thermal detector. Standard thermal detectors are generally not as sensitive and as fast as photon detectors but present the important advantage of being operable at room temperature.

A typical structure used in thermal detectors employs a thermistor layer comprising single-crystalline quantum well layers and barrier layers grown on a substrate, as disclosed in patent US6292089. Such a thermistor layer can be described as a stack of said quantum well layers and barrier layers grown on top of each other, in which charge carriers are trapped in the quantum well layers under steady-state conditions. When infrared radiation is incident on the structure, the absorbed radiation induces an increase in temperature, which is then sensed by measuring the change in resistance of the thermistor layer using electric contacts provided at the top and the bottom of the thermistor layer. In such a thermistor layer the temperature coefficient is determined by the width of the quantum well layers and the barrier layers, and the materials composing these layers. For instance, a temperature coefficient larger than 4 %/K and low noise level detectors have been achieved with a thermistor layer based on AlGaAs/GaAs. However, one disadvantage of the structure set forth in US6292089 is that this high temperature coefficient is not applicable for other material combinations. For instance, the temperature coefficient is limited to about 2 %/K only in the case of $Si_{1-x}Ge_x/Si$ based quantum wells.

Summary of the Invention

An objective of the invention is to provide an alternative structure for thermal sensing comprising a thermistor layer.

This object is met by the invention as defined in the independent claims. Specific embodiments of the invention are defined in the dependent claims. In addition, the present invention has other advantages and features apparent from the description below.

The present invention is based on the understanding that an alternative structure for thermal sensing can be achieved using a thermistor layer based on quantum dots.

According to a first aspect of the present invention, there is provided a solid-state structure for thermal sensing carried by a substrate, wherein the solid-state structure comprises a plurality of stacked layers including a heating absorption layer and a thermistor layer having a resistance inversely related to its temperature, wherein the thermistor layer comprises at least one layer provided with quantum dots, which are made of a first semiconductor material and surrounded by a second semiconductor material, which acts as a barrier material, such that a trapping of charge carriers in the quantum dots is enabled.

A great advantage of the structure of the present invention is that it is applicable for a wide range of materials since less consideration has to be taken regarding lattice mismatch, i.e. the material of the quantum dots can be chosen more freely with respect to the surrounding material, thus enabling a great freedom in design.

In an embodiment of the present invention, the quantum dots are made of single-crystalline material, i.e. of a material without grain boundaries, thus ensuring low noise levels in the detection. Hence, thermal detectors providing high signal to noise ratio can be achieved.

In an embodiment of the present invention, the arrangement of a first band gap and a second band gap of the respective first and second semiconductor material creates an energy barrier such that a trapping of at least one type of charge carriers in said quantum dots is enabled.

In an embodiment of the present invention, the energy level of the valence band of the first semiconductor material is higher than the energy level of the valence band of the second semiconductor material. In another embodiment of the present invention, the energy level of the conduction band of the first semiconductor material is lower than the energy level of the conduction band of the second semiconductor material. These two conditions provide an energy barrier in the valence band or the conduction band, respectively, for trapping holes or electrons, respectively, in the first semiconductor material.

In yet a further embodiment, the activation energy provided by the arrangement of the first and second band gaps of the respective first and second semiconductor material is in the range of 200-850 meV, and preferably about 310 meV. High activation energy results in significant variation of the number of charge carriers which can escape the quantum dots at different temperatures, thus providing thermal detectors of high sensitivity.

In another embodiment of the present invention, the first semiconductor material comprises a compound including a group IV material, and preferably a germanium compound, and the second semiconductor material comprises silicon. Thus, the structure can be achieved using silicon or silicon-compatible technology. Hence, cost-effective production of efficient thermal detectors is enabled.

In other embodiments is provided a structure having a thermistor layer where the first semiconductor material comprises an In compound, and preferably an In compound including a group V material, and the second semiconductor material comprises GaAs; or where the first semiconductor material comprises an In compound, preferably an In compound including a group V material, and the second semiconductor material comprises InP; or where the first semiconductor material comprises a group III nitride. In the context of this invention, a group III or a group V material is a material selected from the column 3b or 5b, respectively, in the periodic table of elements.

In another embodiment, the longest dimension defining the size of the quantum dots is comprised in the range of 1-500 nm, and preferentially in the range of 10-200 nm. For germanium quantum dots surrounded by silicon, wherein the size of the quantum dots is characterized by a longest dimension comprised in the range of about 20-100 nm and another dimension, perpendicular to said longest dimension, comprised in the range of about 2-16 nm, a temperature coefficient in the range of about 4-5.6 %/K can be achieved, which is very advantageous as compared to temperature coefficients provided by prior art thermistor layers made of the same materials.

In another embodiment, the structure further comprises a first electric contact layer arranged on a first side of the thermistor layer, and in electrical contact therewith, and a second electric contact layer arranged on the opposite side of the thermistor layer, and in electrical contact therewith, such that resistance measurements between the first electric contact layer and the second electric contact layer is enabled.

In another embodiment, a solid-state device comprising a first and a second structure is provided, wherein each structure comprises an absorption layer and a thermistor layer as previously defined, wherein the thermistor layer of the first structure is separated from the thermistor layer of the second structure by an isolator, wherein the first structure further comprises a first electric contact layer arranged at a first face of its thermistor layer and in electric contact therewith, wherein the second structure comprises a second electric contact layer arranged at a first face of its thermistor layer and in electric contact therewith, wherein the first electric contact layer is separated from the second electric contact layer by an isolator, wherein the first and second structures are connected by a contact layer having a first side facing the respective second face of said thermistor layers, and wherein the first and second electric contact layers enable resistance measurements there between.

In another embodiment, the structure further comprises an electric contact layer arranged on one side of the thermistor layer and in electrical contact therewith, wherein the electric contact layer is separated by an isolator in a first and a second electrode such that resistance measurements between the electrodes is enabled.

In another embodiment, the structure further comprises a first electrode arranged at a first end of the thermistor layer and in electrical contact therewith, and a second electrode arranged at an opposite end of the thermistor layer and in electrical contact therewith, such that resistance measurements between the electrodes is enabled.

In another embodiment, the structure further comprises a support member arranged to connect the structure to a readout circuit and arranged to thermally isolate the structure from the readout circuit.

In addition, the structure of the present invention may be arranged as a pixel element, which, when associated to a plurality of substantially similar pixel elements, forms a pixellated detector. Such pixellated detectors can then be employed in e.g. uncooled infrared camera. In yet a further embodiment, the pixellated detector further comprises a filter arranged to select a wavelength range of the incoming radiation and to provide the pixel elements with said selected wavelength range.

According to a second aspect of the present invention, a solid-state structure is used for thermal sensing, wherein the solid-state structure comprises a thermistor layer carried by a substrate and having a resistance inversely related to its temperature, wherein the thermistor layer comprises at least one layer provided with quantum dots, which are made of a first semiconductor material and surrounded by a second semiconductor material, which acts as a barrier material, such that a trapping of charge carriers in the quantum dots is enabled.

The use of such a solid-state structure provides efficient uncooled structures for measuring incident infrared radiation in infrared detectors as well as efficient structures for measuring the temperature of a material with which the substrate, on which the thermistor layer of the present invention is carried, is in thermal contact. These solid-state structures can also be used to measure radiation in the far infrared range (wavelengths from 25 $\mu$m to 100 $\mu$m) and terahertz spectrum (wavelengths from 100 $\mu$m to 1 mm).

Generally, all terms used in the claims are to be interpreted according to their ordinary meaning in the technical field, unless explicitly defined otherwise herein. All references to "a/an/the [element, device, component, means, step, etc]" are to be interpreted openly as referring to at least one instance of said element, device, component, means, step, etc., unless explicitly stated otherwise. Other objectives, features and advantages of the present invention will appear from the following detailed disclosure, from the attached dependent claims as well as from the drawings.

Brief Description of the Drawings

The above, as well as additional objects, features and advantages of the present invention, will be better understood through the following illustrative and nonlimiting detailed description of preferred embodiments of the present invention, with reference to the appended drawings, wherein the same reference numerals are used for similar elements, and in which:

Fig. 1a is a schematic view of the structure of a thermal detector in accordance with an embodiment of the present invention.
Fig. 1b is a schematic view of the structure of a thermal detector in accordance with another embodiment of the present invention.
Fig. 2a, Fig. 2a', Fig. 2b, Fig. 2c, Fig. 2c', Fig. 2d and Fig. 2e are schematic illustrations of different band gap configurations for trapping charge carriers in a semiconductor.
Fig. 3a is a schematic view of the structure of a thermal detector showing a first configuration of contacts arranged for vertical detection in accordance with another embodiment of the present invention.
Fig. 3b is a schematic view of the structure of a thermal detector showing a second configuration of contacts arranged for vertical detection in accordance with another embodiment of the present invention.
Fig. 4a is a schematic view of the structure of a thermal detector showing a first configuration of contacts arranged for lateral detection in accordance with another embodiment of the present invention.
Fig. 4b is a schematic view of the structure of a thermal detector showing a second configuration of contacts arranged for lateral detection in accordance with another embodiment of the present invention.
Fig. 5 is a schematic view of the structure of a thermal detector further comprising a support member in accordance with another embodiment of the present invention.
Fig. 6a is a more detailed schematic view of the structure of a thermal detector in the case of vertical detection in accordance with another embodiment of the present invention.
Fig. 6b is a more detailed schematic view of the structure of a thermal detector in the case of lateral detection in accordance with another embodiment of the present invention.

Detailed Description of Embodiments of the Invention

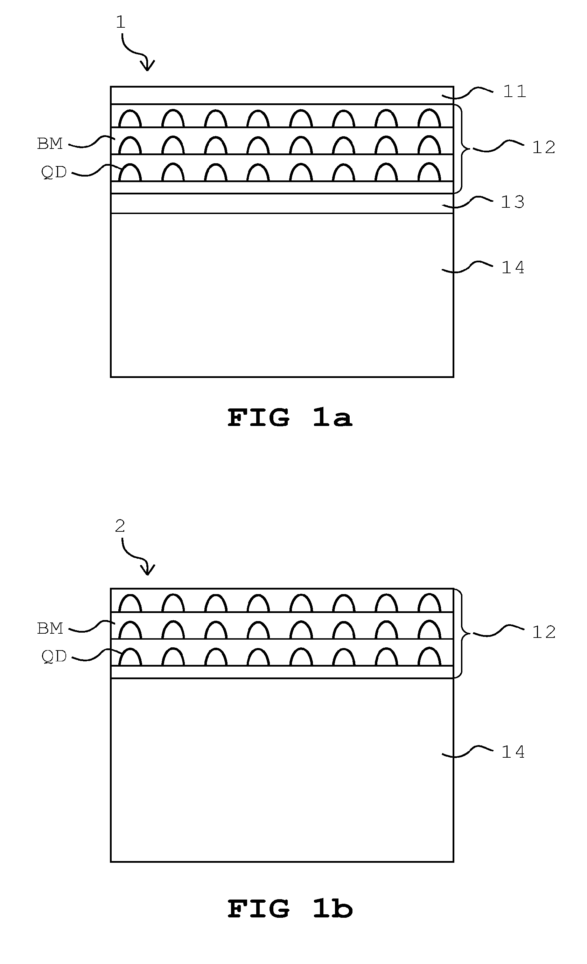

With reference to Fig. 1a, a first embodiment of the present invention will be described below.

As can be seen in Fig. 1a, a solid state structure 1 comprising a heating absorption layer 11, a thermistor layer 12 and a reflector layer 13 is carried by a substrate 14. In this embodiment, the thermistor layer 12 is located between the heating absorption layer 11 and the reflector layer 13, wherein the absorption layer 11 is preferably arranged on top of the structure 1, i.e. at the side of incidence of the radiation. As explained above, the heating absorption layer 11 and the reflector layer 13 are provided to form a structure 1 enabled to absorb as much of the incoming radiation as possible and enabled to enhance the raise in temperature in the structure 1. On one side of the structure 1, the absorption layer 11 is used to absorb as much of the incoming radiation as possible and is arranged to warm up the structure 1, thus enhancing the sensitivity of the structure 1. On the other side, the reflector layer 13 is used to reflect back the radiation which has not been absorbed by the absorption layer 11 or the thermistor layer 12, further enhancing the sensitivity of the structure 1. However, as illustrated in Fig. 1b, the structure 2 can also work as a sensitive structure in a thermal detector without the heating layer 11 and the reflector layer 13. Both the heating absorption layer and the reflector layer are optional.

The thermistor layer 12 comprises at least one layer provided with quantum dots QD made of a first semiconductor material SC1, which is surrounded by a second semiconductor material SC2 acting as a barrier material BM. The barrier material BM is selected such that charge carriers are trapped within the quantum dots QD under steady-state conditions.

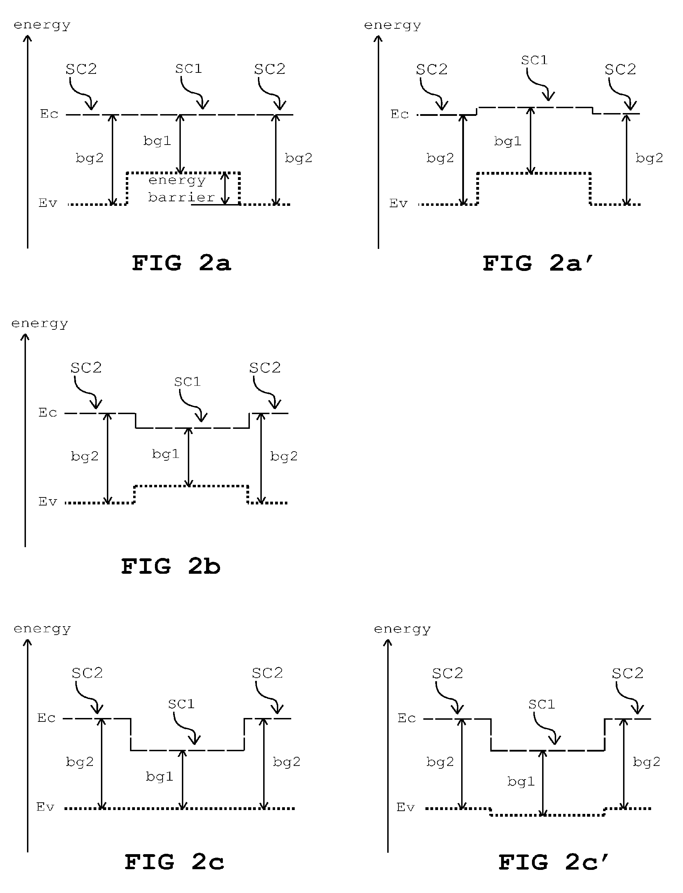

The trapping of the charge carriers in the quantum dots QD can be achieved when the band gaps of the first and the second semiconductor materials SC1 and SC2 are arranged to create an energy barrier for trapping the charge carriers localized within the quantum dots in either (or both) the valence band or the conduction band. Starting with two semiconductor materials SC1 and SC2 having two different band gaps bg1 and bg2, seven typical band gap configurations providing charge trapping in the first semiconductor material SC1 are schematically illustrated in Fig. 2a to Fig. 2e. These configurations illustrate three typical groups of heterostructures commonly defined as type I where both electrons and holes are trapped inside the quantum dots QD made of the first semiconductor material SC1, for example InAs quantum dots embedded in GaAs; type II where only charge carriers of one type are trapped inside the quantum dots QD made of the first semiconductor material SC1 (i.e. either electrons or holes), e.g. Ge quantum dots embedded in Si; and type III where the junction of the first and second semiconductor materials SC1 and SC2 forms a so-called broken gap (see explanation below), e.g. InSb quantum dots embedded in GaInSb.

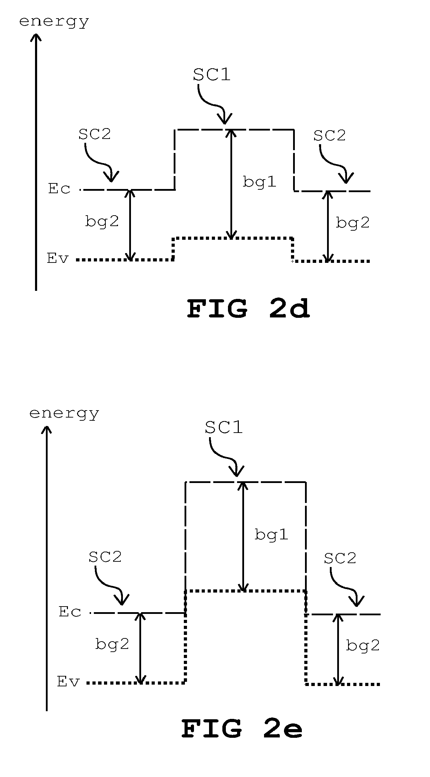

In Fig. 2a to Fig. 2c', the band gap bg1 of the first semiconductor SC1 is smaller than the band gap bg2 of the second semiconductor SC2, while the band gap bg1 of the first semiconductor SC1 is larger than the band gap bg2 of the second semiconductor SC2 in Fig. 2d and Fig. 2e. The conduction bands are represented by dashed lines while the valence bands are represented by dotted lines. In a first configuration (Fig. 2a), the energy band diagrams of the two semiconductors SC1 and SC2 are matched in such a manner that the conduction bands of the two semiconductors are aligned, thus creating an energy barrier in the valence band of the first semiconductor material SC1, which can then trap charge carriers (here holes are trapped in SC1). Note that this configuration (Fig. 2a) is only given as an illustrative example since, in practice, it is not so common that the conduction band of the first semiconductor material SC1 and the conduction band of the second semiconductor material SC2 have exactly the same energy level. Therefore, more commonly another energy barrier smaller than the energy barrier created in the valence band is also present in the conduction band (see Fig. 2a'). This later configuration corresponds to heterostructures of type II.

In a second configuration (Fig. 2b), the energy band diagram of the first semiconductor material SC1 is shifted downwards along the energy axis compared to the configuration shown in Fig. 2a, thus creating an energy barrier both in the conduction band (for electrons) and in the valence band (for holes). Thus, charge carriers (both electrons and holes) are trapped in the first semiconductor SC1. This configuration (Fig. 2b) corresponds to heterostructures of type I.

In a third configuration (Fig. 2c), the energy band diagram of the first semiconductor SC1 is even more shifted downwards along the energy axis compared to the configurations shown in Fig. 2a and Fig. 2b so that the valence bands of the first and second semiconductor materials SC1 and SC2 are aligned. In this configuration (Fig. 2c), an energy barrier for electrons is created in the conduction band, thus trapping charge carriers in the first semiconductor SC1. Note that this configuration (Fig. 2c) is only given as an illustrative example since, in practice, it is not so common that the valence band of the first semiconductor material SC1 and the valence band of the second semiconductor material SC2 have exactly the same energy level. Therefore, more commonly another energy barrier smaller than the energy barrier created in the conduction band is also present in the valence band (see Fig. 2c'). This later configuration corresponds to heterostructures of type II. In these five first cases (Fig. 2a to Fig. 2c'), the quantum dots are made of the first semiconductor material SC1 and the barrier material is made of the second semiconductor material SC2, the band gap bg1 of the first semiconductor material SC1 being smaller than the band gap bg2 of the second semiconductor material SC2. As a result, the charge carriers are trapped in the quantum dots QD.

However, other configurations, where the band gap bg1 of the first semiconductor material SC1 can be larger than the band gap bg2 of the second semiconductor material SC2, are possible, as illustrated in Fig. 2d and Fig. 2e. In Fig. 2d, the energy band diagram of the second semiconductor material SC2 is shifted so far downwards along the energy axis compared to the band diagram of the first semiconductor material SC1 that an energy barrier for the holes localized within the first semiconductor material SC1 is created in the valence band. This configuration corresponds to heterostructures of type II, where one type of carriers (here holes) are trapped in the quantum dots made of the first semiconductor material SC1. Thus, the second semiconductor material SC2 having a smaller band gap than the first semiconductor material SC1 acts as a barrier material BM in this case. Similarly, note that in Fig. 2d an energy barrier is created for the electrons localized in the second semiconductor material SC2. Thus, in this configuration (Fig. 2d), depending on whether the operation principle is based on electrons or holes, SC2 could be used as quantum dots material or barrier material, respectively. It will also be appreciated by a person skilled in the art that a similar configuration as that described in Fig. 2d could be obtained if the energy band diagram of the semiconductor material having the smallest band gap was shifted so far upwards along the energy axis that an energy barrier would be created in the conduction band for the charge carriers (electrons) localized within the semiconductor material having the largest band gap SC1 (this configuration is not shown). In these last cases (configuration shown in Fig. 2d and similar ones), the semiconductor material having the smallest band gap can be used as the barrier material BM while the semiconductor material having the largest band gap can be used for the quantum dots QD, which is the opposite to what was described in configurations depicted in Fig. 2a to Fig. 2c'.

In Fig. 2e, the junction of the first and second semiconductor materials SC1 and SC2 forms a so-called broken gap. In this case, the two band gaps bg1 and bg2 are not overlapping, i.e. that the valence band of one material is higher than the conduction band of the other material. As represented in Fig. 2e, the valence band of the first semiconductor material SC1 is at a higher energy level than the conduction band of the second semiconductor material SC2. In this case, charge carriers of one type, here holes, are trapped in the first semiconductor material SC1 while charge carriers of the other type, here electrons, are trapped in the second semiconductor material SC2. This configuration corresponds to heterostructures of type III.

Some of these configurations (in particular the configurations shown in Fig. 2d, Fig. 2e and similar ones) can even be obtained when using semiconductors having substantially equal band gaps (bg1 $\approx$ bg2). These different configurations, i.e. the relative positions of the band energy diagrams of the first and second semiconductors SC1 and SC2, depend on which semiconductor materials are combined.

Referring again to Fig. 1a, the whole structure 1 can also be designed as a so-called λ/4-cavity. The topmost layer in this cavity is the absorption layer 11 which is matched to the vacuum impedance of 377 ohms/square in order to minimize the reflection of the incident radiation. The bottom of the λ/4-cavity is a reflector layer 13, which reflects all the incoming radiation, enabling standing waves in the cavity. The layer 12 between the absorption layer 11 and the reflector layer 13 should have a thickness of λ/(4n), where λ is the wavelength range which the structure is arranged to absorb and n the refractive index.

The quantum dots QD could for example be designed to absorb at another wavelength than the wavelength range corresponding to the whole design of the structure 1, which would then increase the absorption range of the whole structure outside the wavelength range covered by the absorption corresponding to the design of the structure (λ/4-cavity) only.

In another embodiment the quantum dots are made of single-crystalline material for substantially reducing noise induced by grain boundaries.

In e.g. an infrared detector, when infrared radiation is incident on the structure, the thermistor layer warms up and its resistance is altered. The amount of incident radiation is then related to the change in resistance measured laterally or vertically across the thermistor layer. Absorption of infrared radiation takes place mainly in the absorption layer, but also through free carrier absorption, excitation of trapped carriers in the quantum dots and photon-phonon coupling.

The realization of such a structure 1 or 2 is possible using standard techniques of the semiconductor industry. The quantum dots QD may be produced using epitaxial growth, such as MOVPE or MBE. These techniques enable to produce single crystalline quantum dots QD, i.e. quantum dots QD of high material quality without grain boundaries, which, otherwise, usually are source of noise in thermal detectors. Using epitaxial growth, the material grows atom layer after atom layer without any defects (single-crystal), and the quantum dots QD are self-organized at the surface of the substrate. This self assembly method is known as the Stranski Krastanow method. The shape of the quantum dots QD resulting from this self assembly method is either lens shaped or of pyramidal shape. However, the quantum dots QD can also be formed by some other methods, for example by prepatterning a deposited thin film with electron beam lithography or nano imprint lithography followed by etching techniques, and any shape could be possible (e.g. quadratic, cylindrical, rectangular), as exemplified in Fig. 1, Fig. 5 and Fig. 6 where the quantum dots QD are represented with different shapes.

As the quantum dots QD may have many different shapes, we will define the size of the quantum dots either by its volume or by an order of dimension representing the longest dimension of the quantum dot structure. For instance, in the case of a quantum dot QD having the form of a circular cylinder whose height is larger than its diameter, the size - or the longest dimension - of the quantum dot will be the height of the cylinder. Thus, depending on the shape of the quantum dot QD, the size we will refer to could for instance be associated to a diameter, a width or a height. It is sometimes more preferable to describe the quantum dots QD by their size than by their volume as it is a more common way of description in the field of semiconductor technology. However, the quantum dots can also be characterized by their volume, which, in relation to the size, should be adjusted to optimize the temperature coefficient of the thermistor layer (see explanation below).

The above-mentioned fabrication techniques can for instance be used to produce quantum dots including a group IV material, and in particular germanium quantum dots on a silicon substrate. Such thermistor layers comprising said germanium quantum dots have high temperature coefficient, at least higher than the temperature coefficient obtained for thermistor layers based on quantum-wells where a compound in the form of $Si_{1-x}Ge_x$ has to be grown. The limitation in this case is due to the lattice mismatch in the quantum well structure.

Other material combinations are possible and a thermistor layer 12 in which the quantum dots QD comprise indium or an indium compound, preferably an indium compound including a group V material to form a III-V compound, and the barrier material BM comprises gallium arsenide; or in which the quantum dots QD comprise indium or an indium compound, preferably an indium compound including a group V material to form a III-V compound, and the barrier material BM comprises indium phosphide, may be realized. In one embodiment of the present invention, the quantum dots QD comprise a nitride, for example of group III (B, Al, Ga, In) nitrides. In this latter case, very high temperature coefficients can be achieved since nitrides have very large band gaps, and the difference between the band gap of the barrier material BM and the band gap of the material of the quantum dots QD can be made very large. Using nitrides, it is for instance possible to obtain an activation energy of 820 meV, resulting in temperature coefficient reaching up to 11-12 %/K (see equation 1 below), which is very advantageous as compared to temperature coefficients obtained with prior art quantum well structures.

The following is a more detailed list of material combinations to which the present invention is applicable: p-doped or undoped germanium quantum dots embedded in silicon (Ge/Si), p-doped or undoped silicon germanium quantum dots embedded in silicon (SiGe/Si), p-doped or undoped tin germanium quantum dots embedded in silicon (GeSn/Si), p-doped or undoped tin silicon germanium quantum dots embedded in silicon (SiGeSn/Si), n-doped or undoped indium arsenide quantum dots embedded in gallium arsenide (InAs/GaAs), n-doped or undoped indium gallium arsenide quantum dots embedded in gallium arsenide (In-GaAs/GaAs), n-doped or undoped indium arsenide quantum dots embedded in aluminium gallium arsenide (InAs/AlGaAs), n-doped or undoped indium gallium arsenide quantum dots embedded in aluminium gallium arsenide (In-GaAs/AlGaAs), doped or undoped indium antimonide quantum dots embedded in gallium arsenide (InSb/GaAs), doped or undoped indium antimonide quantum dots embedded in aluminium gallium arsenide (InSb/AlGaAs), doped or undoped indium gallium antimonide quantum dots embedded in gallium arsenide (InGaSb/GaAs), doped or undoped gallium antimonide quantum dots embedded in gallium arsenide (GaSb/GaAs), doped or undoped indium gallium antimonide quantum dots embedded in aluminium gallium arsenide (In-GaSb/AlGaAs), n-doped or undoped indium arsenide quantum dots embedded in indium phosphide (InAs/InP), n-doped or undoped indium gallium arsenide quantum dots embedded in indium phosphide (InGaAs/InP), n-doped or undoped indium gallium arsenide quantum dots embedded in indium gallium phosphide (InGaAs/InGaP), n-doped or undoped indium arsenide quantum dots embedded in indium gallium phosphide (InAs/InGaP). Further, this list could be extended to the following PbTe/CdTe, InGaN/GaN, GaN/AlN, GaN/AlGaN, BN/AlGaN, BAlGaIn/AlGaN, CdSe/ZnSe, CdSe/ZnBeSe, CdSe/ZnCdMgSe, GaAs/AlGaAs, $ZnO/Zn(OH)_2$, ZnMnSe/GaAs, ZnMnTe/ZnTe, ZnCdSe/ZnCdMg and ZnCdSe/ZnCdMgSe, where the first material corresponds to the material of the quantum dot QD and the second material corresponds to the barrier material BM. As can be noticed, the present invention is applicable for a wide range of materials, thus providing a high degree of freedom in the choice of materials, technology and design.

As explained above, the performance of a thermal detector is dependent on the temperature coefficient of the thermistor layer. A high temperature coefficient is advantageous since it results in sensitive detectors. Practically, the temperature coefficient is dependent on the size of the quantum dots QD, and on the properties of the quantum dot material and the surrounding material, wherein the combination of the materials determines an energy barrier for the charge carriers localized within the quantum dots, as illustrated in Fig. 2a to Fig. 2e. Hence, an appropriate selection of the size, shape and composition of the quantum dot QD, the composition and thickness of the barrier material BM and combinations thereof needs to be performed. In the following, a short description on how the temperature coefficient can be calculated is presented. This calculation can be used to select the parameters providing a desired temperature coefficient.

Using a thermistor layer in accordance with the present invention, the temperature coefficient $\beta$ can be expressed as:

$$\beta = \frac{E_a}{k_B} \frac{1}{T_{ref}^2} \qquad (1)$$

where $E_a$ is the activation energy, $k_B$ is the Boltzmann's constant and $T_{ref}$ is the reference temperature at the time of measuring.

Generally, the activation energy $E_a$ depends on the size or volume of the quantum dot QD and on the height of the energy barrier (as shown in Fig. 2a to Fig. 2e) trapping the charge carriers in the quantum dot QD under steady-state conditions.

More specifically, the activation energy $E_a$ increases with increased size or increased volume of the quantum dots QD. The energy barrier, on the other hand, is set by the energy band diagrams of the materials used in the structure, i.e. the material of the quantum dots QD and the barrier material BM, as illustrated in Fig. 2a to Fig. 2e. In particular, the energy barrier depends on the difference in band gaps of the barrier material BM and the material constituting the quantum dot QD multiplied with, depending on whether the operation principle of the structure is based on electrons or holes (negative or positive charge carriers), the offset of the conduction or the valence bands, respectively.

In one embodiment, the longest dimension defining the size of the quantum dots, as described above, is within the range of about 1-500 nm, preferentially in the range of about 10-200 nm. For instance, it is known that germanium quantum dots embedded in a silicon layer can be produced as cylinder-like dots whose diameter typically is in the range of about 20-100 nm and height is in the range of about 2-16 nm. For these materials, the latter quantum dot size results in an activation energy varying between about 310 and 430 meV, providing temperature coefficients in the range of 4-5.6 %/K (in accordance with equation 1), which is very advantageous as compared to temperature coefficients provided by prior art thermistor layers made of the same materials.

Further, in order to maximize the temperature coefficient, the quantum dots QD should be as large as possible and the thickness of the barrier material BM should be thick enough to minimize direct tunnelling between the adjacent dot layers. Thus, a suitable thickness of the barrier material BM is dependent on the size of the quantum dots QD. In addition, the difference in band gap between the quantum dots QD material and the barrier material BM should be as large as possible. The activation energy should preferentially be in the range of about 200-850 meV for obtaining a temperature coefficient in the range of about 2.6-11 %/K. In particular, the resulting activation energy, after optimizing the quantum dot size and the band gap difference, could be about 310 meV in order to get a temperature coefficient of about 4 %/K. It is advantageous to use materials having large band gaps such as nitrides. In conclusion, high activation energy could be obtained either by appropriately choosing the quantum dot QD and the barrier material BM or by adjusting the size of the quantum dots QD.

In addition, the thermistor layer may comprise more than one layer provided with quantum dots QD of a first semiconductor material SC1 surrounded by a second semiconductor material SC2. The number of such layers needs to be adjusted to achieve the desired resistance of the thermistor layer. Between five and fifty layers could be needed but the exact number depends on the resistance of each layer, the desired resistance of the thermistor layer being in the range of 10-200 kΩ, preferably in the range of 30-80 kΩ. The chosen resistance is a trade-off between Johnson noise and self-heating of the pixel since Johnson noise increases with increasing resistance and the self-heating of the pixel decreases with increasing resistance.

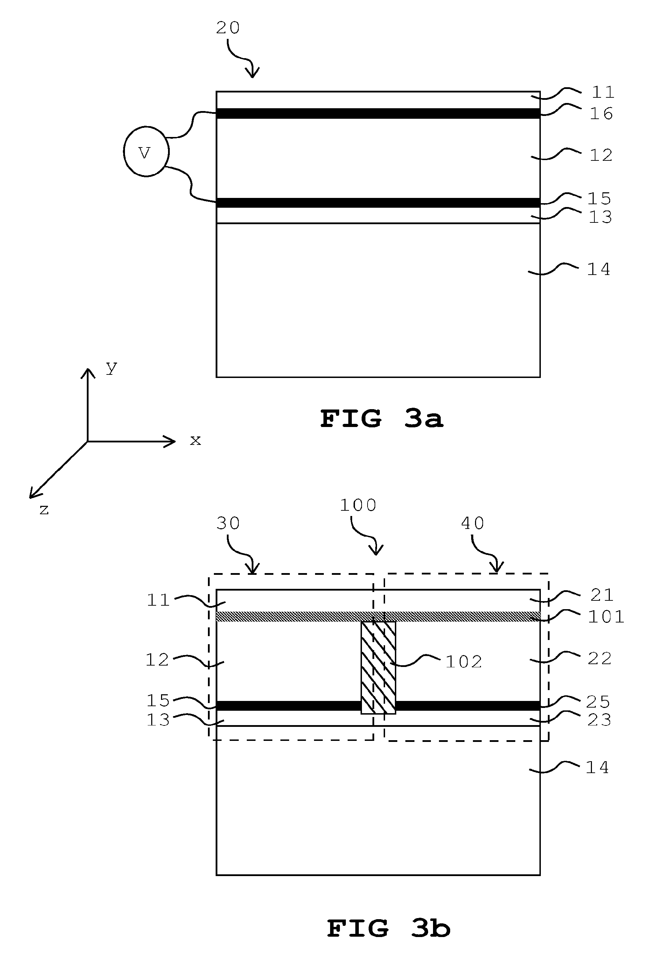

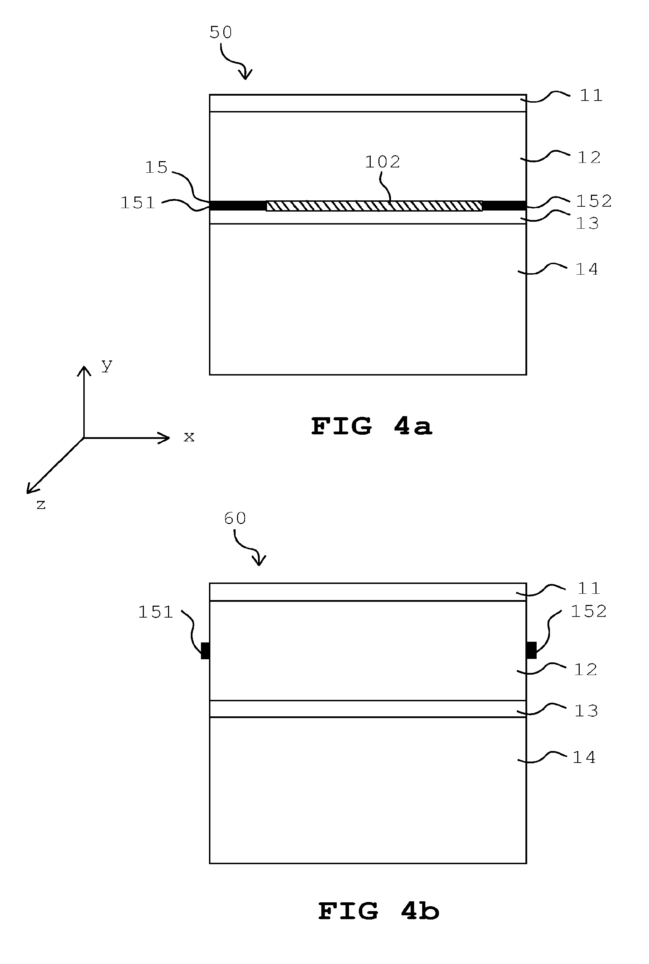

In yet a further embodiment, the structure is provided with electric contacts to measure the changes in resistance across the thermistor layer. Several configurations are possible depending on whether the measurement of the resistance is done "vertically", i.e. substantially along the y-direction as shown in Fig. 3a and Fig. 3b, or "laterally", i.e. along a direction substantially parallel to the (x,z) plane as shown in Fig. 4a and Fig. 4b. Note that since the electrons are confined in all directions, the thermistor layer of the present invention enables lateral detection as well as vertical detection. The structure will not be "short-circuited" in the lateral direction as it is the case for prior art quantum well structures. Examples of different configurations used for contacting the thermistor layer are explained below.

With reference to Fig. 3a and Fig. 3b, vertical detection, e.g. along the y-axis, will now be explained. In a first approach, Fig. 3a schematically illustrates a semiconductor structure 20, which is equal to the one described with reference to Fig. 1a except that a first electric contact layer 15 is arranged on, and preferably in contact with, a first face or side of the thermistor layer 12 and that a second electric contact layer 16 is arranged on, and preferably in contact with, an opposite face or side of the thermistor layer 12. The first electric contact layer 15 is located between the reflector layer 13 and the thermistor layer 12, and the second electric contact layer 16 is located between the heating absorption layer 11 and the thermistor layer 12. The resistance of the thermistor layer 12 can then be measured by a voltmeter V connected between the first and the second electric contacts layers 15 and 16, as shown in Fig. 3a. In a second approach, as illustrated in Fig. 3b, a solid state device 100 comprises two structures 30 and 40 as indicated by dashed lines, wherein each structure comprises a heating absorption layer 11 and 21, respectively; a reflector layer 13 and 23, respectively; and a thermistor layer 12 and 22, respectively. In other words, the structures 30 and 40 are equal to the structure described with reference to Fig. 1a. The thermistor layer 12 of the first structure 30 is separated or substantially isolated from the thermistor layer 22 of the second structure 40 by an isolator e.g. an isolating trench 102. As can be seen in Fig. 3b, said two heating layers 11 and 21 are joined to form one continuous layer, as are said reflector layers 13 and 23. However, the absorption layers 11 and 21 and/or the reflector layers 13 and 23 may also be separated from one another by e.g. an insulator. Further, a first electric contact layer 15 is arranged at, and preferably in contact with, a first face of the thermistor layer 12 of the first structure 30 between the reflector layer 13 and the thermistor layer 12, and a second electric contact layer 25 is arranged at, and preferably in contact with, a first face of the thermistor layer 22 of the second structure 40 between the reflector layer 23 and the thermistor layer 22. The electrical contact layer 15 is electrically separated or substantially isolated from the electrical contact layer 25 by an isolator e.g. said isolating trench 102. In addition, both structures 30 and 40 are electrically connected to each other by a common contact layer 101 having a first side facing the respective second face of the thermistor layers 12 and 22. In the device 100 described in Fig. 3b, the electric contact layers 15 and 25 are located between the respective reflector layers 13 and 23 and the respective thermistor layers 12 and 22 while the common contact layer 101 is located between the heating absorption layers 11 and 21 and the thermistor layers 12 and 22. However, the electric contact layers 15 and 25 could also be located between the respective heating absorption layers 11 and 21 and the respective thermistor layers 12 and 22. The common contact layer 101 would then be located between the reflector layers 13 and 23 and the thermistor layers 12 and 22. In any case, the resistance of the device 100 described with reference to Fig. 3b can be measured between the first electric contact layer 15 and the second electric contact layer 25, the common contact layer 101 being used to connect the first structure 30 with the second structure 40. In other words, this configuration corresponds to the measurement of two resistances mounted in series. This configuration has the advantage to save some space in the vertical direction, i.e. along the y-axis.

The common contact layer 101 is arranged to contact the two thermistor layers 12 and 22. This layer 101 can be made of highly-doped semiconductor material or any other highly conductive materials. This layer 101 should preferably also have good thermal conductivity in order to transfer the heat from the absorption layers 11 and 21 to the thermistor layers 12 and 22.

The isolating trench 102 can be realized by e.g. first etching a trench or a hole in a thermistor layer by means of lithography and etching techniques, and then filling the trench with an isolating material such as an oxide or silicon nitride, thereby creating two thermistor layers 12 and 22 separated from one another by the isolating trench 102. It will be appreciated by a person skilled in the art that the isolating material could be other materials than an oxide or silicon nitride and that the width of the trench should be thick enough to sufficiently reduce or minimize electrical conduction between the two thermistor layers 12 and 22.

With reference to Fig. 4a and Fig. 4b, lateral detection, e.g. along a direction substantially parallel to the (x, z)-plane, will now be explained. In a first approach, Fig. 4a schematically illustrates a solid state structure 50, which is equal to the one described with reference to Fig. 1a except that a first electric contact layer 15 is arranged on, and preferably in contact with, one side of said thermistor layer 12, wherein the electric contact layer 15 is separated in two parts substantially isolated from one another by an isolator 102 to create first and second electrodes 151 and 152. The electrodes 151 and 152 are located between the reflector layer 13 and the thermistor layer 12. The resistance of the thermistor layer 12 can then be measured between the first electrode 151 and the second electrode 152. The electrodes 151 and 152 separated by an isolator 102 may alternatively be arranged on, and preferably in contact with, the opposite side of the thermistor layer 12 than the one depicted in Fig. 4a, i.e. between the absorption layer 11 and the thermistor layer 12. The isolator 102 can be an oxide or a silicon nitride layer but could also be made of other isolating materials. In a second approach, Fig. 4b schematically illustrates a solid state structure 60, which is equal to the one described with reference to Fig. 1a except that a first electrode 151 is arranged at a first end of the thermistor layer 12, i.e. a side substantially parallel to the y-axis, and a second electrode 152 is arranged at an opposite end of the thermistor layer 12. The resistance can then be measured between the first electrode 151 and the second electrode 152.

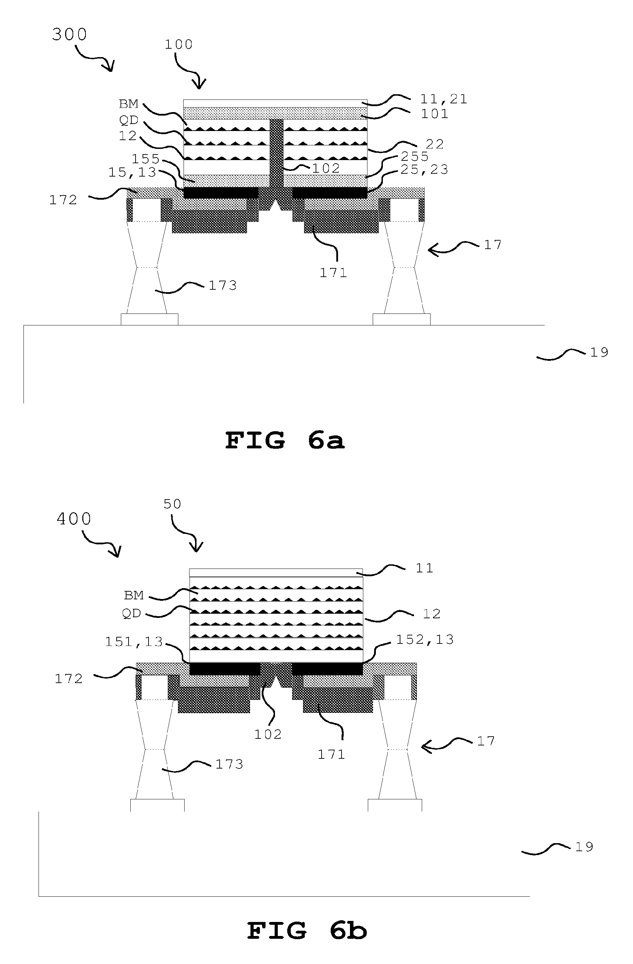

Regarding the realization of the contact layers or electrodes, it will be appreciated by a person skilled in the art that layers of doped materials could be deposited or grown between the epitaxially grown film 12 comprising the quantum dots QD and the contact layers or electrodes 15, 151, 152 and 16 in order to enable good ohmic contacts. This will be illustrated with reference to Fig. 6 below. Standard deposition and etching techniques can be employed to form the contacts layers or electrodes 15, 151, 152 and 16.

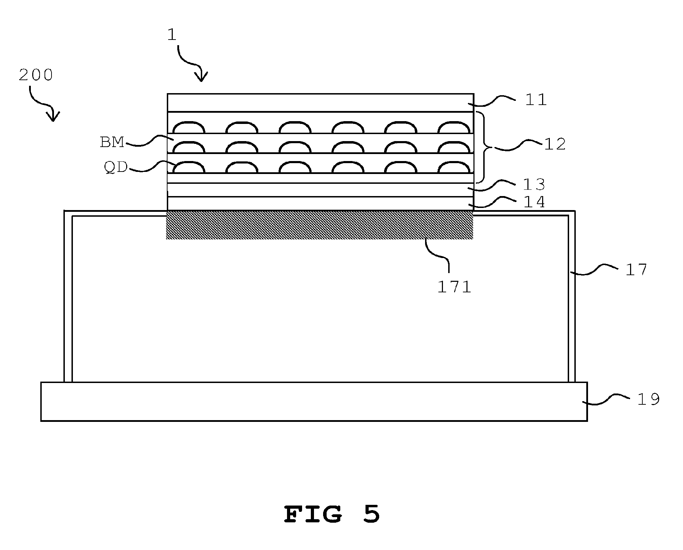

In a further embodiment, as schematically shown in Fig. 5, the structure 1 (equal to the one described with reference to Fig. 1a) further comprises a support member 17 arranged to connect the structure 1 to a readout circuit 19 and arranged to thermally isolate the structure 1 from the readout circuit 19, thus forming a pixel element 200. In a first alternative, the support member 17 may be partially formed from the substrate 14 carrying the structure 1, the back side (side opposite to the side on which the thermistor layer 12 has been grown) of the substrate 14 having being etched to form a cavity acting as an isolator between the readout chip 19 and the structure 1. The cavity could be filled with e.g. air, forming a so-called air-bridge, or sufficient isolation would also be obtained if the cavity was under vacuum. In this case and with reference to Fig. 1a, this is the side of the substrate 14 opposite to the side on which the film or the layer 12 comprising the quantum dots QD has been grown that is used to connect the structure 1 with the readout chip 19. In other words, the remaining parts of the bulk of the substrate 14 constitutes the support member 17. In a second alternative, the substrate carrying the structure 1 is bonded to a readout chip 19 by means of resist or epoxy, the side of the substrate 14 used as an interface to mount the structure 1 on the readout chip 19 being the side on which the thermistor layer 12 has been grown. In this case, as opposite to what is shown in Fig. 1a, the first layer to be grown on the substrate 14 would preferably be the absorption layer 11 and not the reflection layer 13 so that, after the structure 1 is mounted on the readout circuit 19, the absorption layer 11 is located at the side of incidence of the radiation. Additionally, the support member 17 can be provided with an isolator 171 to ensure further thermal isolation from the readout circuit 19. Electrical contact is then established between the contacts layers or electrodes 15, 151, 152, 16, and 25 of the structure 1 and the readout chip 19 by means of electrically-conductive pillars or interconnects 173 (shown in Fig. 6a and Fig. 6b) going through the epoxy or resist layer. At this point, the substrate can be thinned down by lapping, etching or polishing the side opposite to the side on which the structure has been grown, which is also the side of the substrate not facing the readout chip 19 (as explained above). The epoxy or the resist can thereafter be etched away, thereby creating a cavity (or an air bridge) between the readout chip 19 and the structure 1, the interconnects 173 constituting part of the support member 17. The cavity has the function to isolate the structure 1 from the readout chip 19.

Further, Fig. 6a and Fig. 6b show the structures 100 and 50 mounted on a support member 17 for vertical and lateral detection, respectively. Each support member 17 shown in Fig. 6a and Fig. 6b comprises an isolator 171, metal legs 172 and interconnects 173. The isolator 171 and the metal legs 172 can be fabricated by employing standard techniques of the semiconductor technology during the fabrication of the structures 100 and 50. The isolator 171 could be a layer of any insulating material such as an oxide or a silicon nitride layer ensuring isolation of the structures 100 and 50. The metal legs 172 are used to connect the contact layers or electrodes 15, 151, 152, 16 and 25 of the structures 100 and 50 to the interconnects 173 of the support member 17. The metal legs 172 are preferentially made of conductive materials such as metals. As explained above, the interconnects 173 of the support member 17 could either be formed from the substrate 14 carrying the structures 100 and 50 or could be specifically grown electrically-conductive pillars, grown for instance by electroplating, which go through the epoxy or resist layer when bonding the structures 100 and 50 on the readout chip 19. In any case, the interconnects 173 are used to create a cavity (also called air bridge when filled with air) to isolate the structures 100 and 50 from the readout chip 19.

Fig. 6a illustrates a pixel element 300 where the structure 100 is connected to a readout chip 19 via a support member 17. The structure 100 is similar to that depicted in Fig. 3b, i.e. designed for vertical detection, where an isolator 102 is used to isolate a first thermistor layer 12 from a second thermistor layer 22. Note that doped contact layers 155 and 255 are arranged between the thermistor layers 12 and 22 and the contact layers 15 and 25, respectively. These doped contact layers 155 and 255 are provided to improve the ohmic contact between the thermistor layers 12 and 22 and the contact layers 15 and 25, respectively.

Fig. 6b illustrates a pixel 400 where the structure 50 is connected to a readout chip 19 via a support member 17. This structure 50 is similar to that depicted in Fig. 4a, i.e. designed for lateral detection, where an isolator 102 is provided between the two electrodes 151 and 152.

Note that in Fig. 6a and Fig. 6b, the material constituting the isolator 171 of the support member 17 is the same material constituting the isolator 102. It is also to be noted that in both Fig. 6a and Fig. 6b, the material constituting the contact layers or electrodes 15, 151, 152 and 25 is also used as a reflector layer 13 and 23, which has the advantage to simplify the fabrication procedure of the structure.

The pixel elements 300 or 400 are suitable for pixellated light-sensitive detectors in which a plurality of substantially identical pixel elements are arranged as an array. Further, a filter (not shown in the figures) can be arranged on the pixellated detector, at the side of incidence of radiation, to select a wavelength range of the incoming radiation and to provide the pixel elements 200 or 300 with the selected wavelength range.

On a processing point of view, the structures 100 or 50 would in principle be connected to the read-out circuit 19 through the steps of wafer bonding and thinning of the substrate 14, as explained above. In addition, standard optical lithography, etching and metallization techniques would be used in order to define the pixels and deposit the contacts and the absorption layers. The isolators 102 and 171 could be made of silicon nitride or oxides for instance but could also be made of any other insulating materials. Interconnects between the read-out circuit 19 and the support member 17 could for example be realized by electroplating of contact pillars.

Furthermore, with reference to Fig. 1b, the present invention is applicable for any device wherein a thermistor layer 12 comprising at least one layer provided with quantum dots QD made of a first semiconductor material SC1 and surrounded by a second semiconductor material SC2 acting as a barrier material BM is used for trapping charge carriers in the quantum dots QD. The use of such a thermistor layer 12 is of interest for any application based on thermal sensing and would, in particular, provide efficient uncooled structures for measuring incident infrared radiation in infrared detectors as well as efficient structures for measuring the temperature of a material with which the substrate 14, on which the thermistor layer 12 of the present invention is carried, is in thermal contact.

The present invention is applicable in e.g. infrared-cameras, which have numerous applications such as night-vision systems, search and rescue, detection of isolation problems in houses and inspection of electrical circuits. More generally, the present invention is applicable in any devices using absorption of radiation in the infrared range as for example $CO_2$-detectors.

The invention has mainly been described above with reference to a number of explicitly disclosed embodiments. However, as is readily appreciated by a person skilled in the art, other embodiments than the ones disclosed above are equally possible within the scope of the invention, as defined by the appended patent claims.

**Claims**

1.  A solid-state structure (1) for thermal sensing carried by a substrate (14), wherein said solid-state structure (1) comprises a plurality of stacked layers including a heating absorption layer (11) and a thermistor layer (12) having a resistance inversely related to its temperature, wherein said thermistor layer (12) comprises at least one layer provided with quantum dots (QD), which are made of a first semiconductor material (SC1) and surrounded by a second semiconductor material (SC2), which acts as a barrier material (BM), such that a trapping of charge carriers in said quantum dots (QD) is enabled.

2.  A structure according to claim 1, wherein said quantum dots (QD) are made of single-crystalline material.

3.  A structure according to any one of the preceding claims, wherein the arrangement of a first band gap (bg1) and a second band gap (bg2) of the respective first and second semiconductor material (SC1, SC2) creates an energy barrier such that a trapping of at least one type of charge carriers in one of said quantum dots (QD) is enabled.

4.  A structure according to any one of the preceding claims, wherein the energy level of the valence band of the first semiconductor material (SC1) is higher than the energy level of the valence band of the second semiconductor material (SC2).

5.  A structure according to any one of the preceding claims, wherein the energy level of the conduction band of the first semiconductor material (SC1) is lower than the energy level of the conduction band of the second semiconductor material (SC2).

6.  A structure according to any one of the preceding claims, wherein the activation energy provided by the arrangement of the first and second band gaps (bg1, bg2) of the respective first and second semiconductor material (SC1, SC2) is in the range of 200-850 meV, and preferably about 310 meV.

7.  A structure according to any one of the preceding claims, wherein the first semiconductor material (SC1) comprises a group IV material, and preferably germanium, and the second semiconductor material (SC2) comprises silicon.

8.  A structure according to any one of claims 1-6, wherein the first semiconductor material (SC1) comprises an indium compound, and preferably an indium compound which comprises a group V material, and the second semiconductor material (SC2) comprises gallium arsenide.

9.  A structure according to any one of claims 1-6, wherein the first semiconductor material (SC1) comprises an indium compound, and preferably an indium compound which comprises a group V material, and the second semiconductor material (SC2) comprises indium phosphide.

10. A structure according to any one of claims 1-6, wherein the first semiconductor material (SC1) comprises a nitride, and preferably a group III nitride.

11. A structure according to any one of the preceding claims, wherein the longest dimension defining the size of said quantum dots (QD) is in the range of 1-500 nm, and preferably in the range of 10-200 nm.

12. A structure (20) according to any one of the preceding claims, further comprising a first electric contact layer (15) arranged on a first side of said thermistor layer (12) and in electrical contact therewith, and a second electric contact layer (16) arranged on the opposite side of said thermistor layer (12) and in electrical contact therewith, such that resistance measurements between said first electric contact layer (15) and said second electric contact layer (16) is enabled.

13. A solid-state device (100) comprising a first and a second structure (30, 40), each as defined in claim 1, wherein the thermistor layer (12) of said first structure (30) is separated from the thermistor layer (22) of said second structure (40) by isolating means (102), wherein said first structure (1) further comprises a first electric contact layer (15) arranged at a first face of its thermistor layer (12) and in electric contact therewith, wherein said second structure (2) comprises a second electric contact layer (25) arranged at a first face of its thermistor layer (22) and in electric contact therewith, wherein said first electric contact layer (15) is separated from said second electric contact layer (25) by isolating means (102),

wherein said first and second structures (1, 2) are connected by a contact layer (101) having a first side facing the respective second face of said thermistor layers (12, 22), and

wherein said first and second electric contact layers (15, 25) enable resistance measurements there between.

14. A structure (50) according to any one of claims 1-11, further comprising an electric contact layer (15) arranged on one side of said thermistor layer (12) and in electrical contact therewith, wherein said electric contact layer (15) is separated by isolating means (102) in a first and a second electrode (151, 152) such that resistance measurements between said electrodes is enabled.

15. A structure (60) according to any one of claims 1-11, further comprising a first electrode (151) arranged at a first end of said thermistor layer (12) and in electrical contact therewith, and a second electrode (152) arranged at an opposite end of said thermistor layer (12) and in electrical contact therewith, such that resistance measurements between said electrodes (151, 152) is enabled.

16. A structure according to any one of the preceding claims, further comprising a support member (17) arranged to connect the structure (1) to a readout circuit (19) and arranged to thermally isolate said structure (1) from said readout circuit (19).

17. A structure according to claim 16, wherein said support member (17) is partially formed from said substrate (14).

18. A pixel element (200, 300, 400) comprising a structure as defined in claim 1.

19. A pixellated detector comprising at least one pixel element (200, 300, 400) as defined in claim 18.

20. The pixellated detector as defined in claim 19, further comprising a filter arranged to select a wavelength range of the incoming radiation and to provide said pixel element (200, 300, 400) with said selected wavelength range.

21. Use of a solid-state structure (2) for thermal sensing, wherein said solid-state structure (2) comprises a thermistor layer (12) carried by a substrate (14) and having a resistance inversely related to its temperature, wherein said thermistor layer (12) comprises at least one layer provided with quantum dots (QD), which are made of a first semiconductor material (SC1) and surrounded by a second semiconductor material (SC2), which acts as a barrier material (BM), such that a trapping of charge carriers in said quantum dots (QD) is enabled.

1

BM

QD

11

12

13

14

**FIG 1a**

2

BM

QD

12

14

**FIG 1b**

FIG 2a

FIG 2a'

FIG 2b

FIG 2c

FIG 2c'

**FIG 2d**

**FIG 2e**

20

11
16

V

12

15
13

14

y

x

z

**FIG 3a**

30          100          40

11
21
101

12
102
22

15
25
13
23

14

**FIG 3b**

50

11

12

15

102

152

151

13

14

y

x

z

**FIG 4a**

60

11

151

152

12

13

14

**FIG 4b**

**FIG 5**

300
100

BM
QD
12
155
15,13
172

11,21
101

22
255
25,23

102

171

17

173

19

**FIG 6a**

400
50

BM
QD

11

12

151,13
172

152,13

102

171

173

17

19

**FIG 6b**

# EUROPEAN SEARCH REPORT

**European Patent Office**

**Application Number**

EP 06 12 2274

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,Y | US 6 292 089 B1 (ANDERSSON JAN [SE]) 18 September 2001 (2001-09-18) * the whole document * | 1-21 | INV.<br>H01L31/0352<br>H01L31/09<br>H01L31/109<br>G01K7/22<br>H01L27/146 |
| Y | CHU L ET AL: "Lateral intersubband photocurrent spectroscopy on InAs/GaAs quantum dots" APPLIED PHYSICS LETTERS, AIP, AMERICAN INSTITUTE OF PHYSICS, MELVILLE, NY, US, vol. 76, no. 14, 3 April 2000 (2000-04-03), pages 1944-1946, XP012024989 ISSN: 0003-6951 * abstract; figures 1,3 * * page 1944, left-hand column * | 1-12, 14-21 | ADD.<br>H01L29/12 |
| Y | RYZHII V: "The theory of quantum-dot infrared phototransistors" Semiconductor Science and Technology IOP Publishing UK, vol. 11, no. 5, May 1996 (1996-05), pages 759-765, XP002424898 ISSN: 0268-1242 * abstract; figures 1,2,6 * * page 759, left-hand column * * paragraph [0008] * | 1-3, 6-12, 16-21 | |
| Y | US 5 021 663 A1 (HORNBECK LARRY J [US]) 4 June 1991 (1991-06-04) * abstract; figures 4,5 * | 13 | TECHNICAL FIELDS SEARCHED (IPC)<br><br>H01L<br>G01K |

-/--

The present search report has been drawn up for all claims

| Place of search | Date of completion of the search | Examiner |
|---|---|---|
| The Hague | 15 March 2007 | Heising, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 06 12 2274

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | GOEDE K ET AL: "Calorimetric investigation of intersublevel transitions in charged quantum dots" Physical Review B (Condensed Matter and Materials Physics) APS through AIP USA, vol. 64, no. 24, 15 December 2001 (2001-12-15), pages 245317/1-7, XP002424899 ISSN: 0163-1829 * the whole document * | 1-21 | |
| A | HEINRICH D ET AL: "Optically-induced charge storage in self-assembled InAs quantum dots" THIN SOLID FILMS, ELSEVIER-SEQUOIA S.A. LAUSANNE, CH, vol. 380, no. 1-2, 22 December 2000 (2000-12-22), pages 192-194, XP004226630 ISSN: 0040-6090 * the whole document * | 1-21 | |
| A | JONG-WOOK KIM ET AL: "Room Temperature Far Infrared (8$\sim$10 $\mu$m) Photodetectors Using Self-Assembled InAs Quantum Dots with High Detectivity" IEEE ELECTRON DEVICE LETTERS, IEEE SERVICE CENTER, NEW YORK, NY, US, vol. 21, no. 7, July 2000 (2000-07), XP011018804 ISSN: 0741-3106 * the whole document * | 1-21 | TECHNICAL FIELDS SEARCHED (IPC) |

-/--

The present search report has been drawn up for all claims

| Place of search | Date of completion of the search | Examiner |
|---|---|---|
| The Hague | 15 March 2007 | Heising, Stephan |

EPO FORM 1503 03.82 (P04C01)

**European Patent Office**

## EUROPEAN SEARCH REPORT

Application Number

EP 06 12 2274

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CHAKRABARTI S ET AL: "High-performance mid-infrared quantum dot infrared photodetectors" JOURNAL OF PHYSICS D. APPLIED PHYSICS, INSTITUTE OF PHYSICS PUBLISHING, BRISTOL, GB, vol. 38, no. 13, 7 July 2005 (2005-07-07), pages 2135-2141, XP020083179 ISSN: 0022-3727 * abstract; figures 1-3,7 * | 1-21 | |
| A | OLKHOVETS A ET AL: "Size-dependent temperature variation of the energy gap in lead-salt quantum dots" Physical Review Letters APS USA, vol. 81, no. 16, 19 October 1998 (1998-10-19), pages 3539-3542, XP002424900 ISSN: 0031-9007 * the whole document * | 6,11 | |
| | | | TECHNICAL FIELDS SEARCHED (IPC) |

The present search report has been drawn up for all claims

| Place of search | Date of completion of the search | Examiner |
|---|---|---|
| The Hague | 15 March 2007 | Heising, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 06 12 2274

This annex lists the patent family members relating to the patent documents cited in  the above-mentioned European search report.
The members are as contained in the European Patent Office EDP file on
The European Patent Office is in no way liable for these particulars which are merely given for the purpose of information.

15-03-2007

| Patent document cited in search report | | Publication date | Patent family member(s) | | Publication date |
|---|---|---|---|---|---|
| US 6292089 | B1 | 18-09-2001 | AU | 1325697 A | 01-08-1997 |
| | | | EP | 0873500 A1 | 28-10-1998 |
| | | | JP | 3573754 B2 | 06-10-2004 |
| | | | JP | 2000503121 T | 14-03-2000 |
| | | | SE | 505753 C2 | 06-10-1997 |
| | | | SE | 9600097 A | 12-07-1997 |
| | | | WO | 9725600 A1 | 17-07-1997 |
| US 5021663 | A1 | | NONE | | |

EPO FORM P0459

For more details about this annex : see Official Journal of the European Patent Office, No. 12/82

**EP 1 912 259 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6292089 B